# EUROPEAN PATENT SPECIFICATION

(11) **EP 1 262 002 B1**
(45) Date of publication and mention of the grant of the patent: **20.10.2004**
(21) Application number: 01907965.6
(22) Date of filing: 02.03.2001
(51) Int. Cl.: H01S 5/026, H01L 21/18, H01L 21/266

(54) **QUANTUM WELL INTERMIXING**
QUANTENTOPF-INTERMIXING
MELANGE DE PUITS QUANTIQUES

(30) Priority: 08.03.2000 WO PCT/SG00/00038; 08.03.2000 WO PCT/SG00/00039; 11.09.2000 SG 200004787; 11.09.2000 SG 200004786
(43) Date of publication of application: 04.12.2002
(73) Proprietor: NTU Ventures Pte. Ltd., Singapore 637722 (SG)
(72) Inventor: OOI, Boon Siew, Tanjung Bunga 11200 Penang (MY); LAM, Yee Loy, Singapore 680271 (SG); CHAN, Yuen Chuen, Singapore 138678 (SG); ZHOU, Yan, Singapore 658881 (SG); NG, Geok Ing, Singapore 257722 (SG)
(74) Representative: Finnie, Peter John
(86) International application number: PCT/GB2001/000898
(87) International publication number: WO 2001/067568

(56) References cited:
- EP-A- 0 731 387
- US-A- 6 027 989
- MCLEAN C J ET AL: "Quantum well intermixing with high spatial selectivity using a pulsed laser technique" ELECTRONICS LETTERS,IEE STEVENAGE,GB, vol. 31, no. 15, 20 July 1995 (1995-07-20), pages 1285-1286, XP006003125 ISSN: 0013-5194
- OOI B S ET AL: "QUANTUM-WELL INTERMIXING IN GAAS-ALGAAS STRUCTURES USING PULSED LASER IRRADIATION" IEEE PHOTONICS TECHNOLOGY LETTERS,US,IEEE INC. NEW YORK, vol. 9, no. 5, 1 May 1997 (1997-05-01), pages 587-589, XP000677332 ISSN: 1041-1135
- OOI B S ET AL: "Integration process for photonic integrated circuits using plasma damage induced layer intermixing" ELECTRONICS LETTERS,IEE STEVENAGE,GB, vol. 31, no. 6, 16 March 1995 (1995-03-16), pages 449-451, XP006002600 ISSN: 0013-5194 cited in the application
- LAM L M ET AL: "Plasma immersion Ar+ion implantation induced disorder in strained InGaAsP multiple quantum wells" ELECTRONICS LETTERS,IEE STEVENAGE,GB, vol. 34, no. 8, 16 April 1998 (1998-04-16), pages 817-818, XP006009571 ISSN: 0013-5194 cited in the application
- WEE T C L ET AL: "Novel quantum well intermixing in InGaAs-InGaAsP laser structure using argon plasma exposure" CONFERENCE DIGEST. 2000 CONFERENCE ON LASERS AND ELECTRO-OPTICS EUROPE (CAT. NO.00TH8505), CONFERENCE DIGEST. 2000 CONFERENCE ON LASERS AND ELECTRO-OPTICS EUROPE, NICE, FRANCE, 10-15 SEPT. 2000, page 1 pp. XP002172054 2000, Piscataway, NJ, USA, IEEE, USA ISBN: 0-7803-6319-1
- ONG T K ET AL: "Pulsed-laser irradiation quantum well intermixing process in GaInAs/GaInAsP laser structures" MICROELECTRONIC ENGINEERING,ELSEVIER PUBLISHERS BV., AMSTERDAM,NL, vol. 51-52, May 2000 (2000-05), pages 349-355, XP004199399 ISSN: 0167-9317

## Description

### Background to the Invention

The monolithic integration of several optoelectronics devices in optoelectronics integrated circuits (OEICs) and photonic integrated circuits (PICs) is of considerable interest for the development of telecommunications systems.

In OEICs, optical devices such as lasers and electronic devices such as transistors are integrated on a single chip for high speed operation since parasitic reactance in the electrical connections can be minimized from the closely packed devices.

PICs are a subset of OEICs with no electrical components, in which only photons are involved in the communication or connection between optoelectronics and/or photonic devices. The driving forces for PICs are to improve the complexity of next-generation optical communication links, networking architectures and switching systems, such as in multiple channel wavelength division multiplexing (WDM) and high speed time division multiplexing (TDM) systems. In PICs, besides gaining from the low cost, size reduction, and increased packaging robustness, the main advantage is that all the interconnections between the individual guided-wave optoelectronics devices are precisely and permanently aligned with respect to one another since the waveguides are lithographically produced.

In the integration process, complex devices are built up from components that are very different in functionality such as light emitters, waveguides, modulators and detectors. Each component needs different material structures to achieve optimized performance. As a result, the ability to modify the bandgap energy and the refractive index of materials is important in order to realize OEICs and PICs. A number of techniques have emerged for this purpose, including growth and regrowth, selective area epitaxy or growth on a patterned substrate and quantum well intermixing (QWI).

Growth and regrowth is a complicated and expensive technique which involves growing, etching and regrowing of quantum well (QW) layers at selected areas on bulk material. These layer structures are overgrown with the same upper cladding but a different active region. This approach suffers from mismatches in the optical propagation coefficient and mismatches in the dimensions of the waveguide at the regrown interface. In addition, this process gives low yield and low throughput, and therefore adds cost to the final product.

Selective area growth utilizes differences in epitaxial layer composition and thickness produced by growth through a mask to achieve spatially selective bandgap variation. Prior to epitaxy growth, the substrate is patterned with a dielectric mask such as SiO₂, in which slots with different widths are defined. The growth rate in the open areas depends on the width of the opening and the patterning of the mask. No growth can take place on top of the dielectric cap. However, surface migration of the species can take place for some distance across the mask to the nearest opening. The advantage of this approach is a reduction in the total number of processing steps such that essentially optimum laser and modulator multiple quantum well (MQW) sections can be accomplished in a single epitaxial growth stage. This process works well under a precisely controlled set of parameters but is difficult to manipulate in a generic fashion. In addition, this technique gives poor spatial resolution of around 100 µm, and hence the passive section generally has a relatively high loss.

QWI is based on the fact that a QW is an inherently metastable system due to the large concentration gradient of atomic species across the QWs and barriers interface. Hence, this allows the modification of the bandgap of QW structures in selected regions by intermixing the QWs with the barriers to form alloy semiconductors. This technique offers an effective post-growth method for the lateral integration of different bandgaps, refractive index and optical absorption within the same epitaxial layers.

The QWI technique has been gaining recognition and popularity for which several potential applications in integrated optoelectronics have been identified, for example bandgap-tuned electroabsorption modulators, bandgap-tuned lasers, low-loss waveguides for interconnecting components on an OEIC or PIC, integrated extended cavities for line-narrowed lasers, single-frequency distributed Bragg reflector (DBR) lasers, mode-locked lasers, non-absorbing mirrors, gain or phase gratings for distributed feedback (DFB) lasers, superluminescent diodes, polarization insensitive QW modulators and amplifiers and multiple wavelength lasers.

Current research has been focused on QWI using approaches such as impurity free vacancy induced disordering (IFVD), laser induced disordering (LID) and impurity induced disordering (IID). Each of these QWI techniques has its advantages and shortcomings.

The IFVD method involves the deposition of a dielectric capping material on the QW materials and subsequent high temperature annealing to promote the generation of vacancies from the dielectric cap to the QW materials and hence enhance the intermixing at selected areas. For instance, in GaAs-AlGaAs QW materials, SiO₂ is known to induce out-diffusion of Ga atoms during annealing, hence generating group III vacancies in the QW material. The thermal stress at the interface between the GaAs and the SiO₂ layer plays an important role. The thermal expansion coefficient of GaAs is ten times larger than that of SiO₂. During high temperature annealing, the bonding in the highly porous SiO₂ layer deposited using plasma-enhanced chemical vapor deposition (PECVD) may be broken due to the stress gradient between the GaAs and SiO₂ film. Thus, the out-diffusion of Ga helps to relieve the tensile stress in the GaAs. These Ga vacancies then propagate down to the QW and enhance the interdiffusion rate of Ga and Al, and hence result in QWI. After the intermixing process, the bandgap in the QW material widens and the refractive index decreases.

The selectivity of this technique can be obtained using an SrF₂ layer to inhibit the outdiffusion of Ga, hence suppress the QWI process. Using this technique, devices such as multiple wavelength bandgap tuned lasers and multiple channel waveguide photodetectors have been successfully demonstrated.

Although IFVD is a successful technique when employed in GaAs/AlGaAs system, this technique gives poor reproducibility in InGaAs/InGaAsP systems. Furthermore, due to the poor thermal stability of InGaAs/InGaAsP materials, the IFVD process, which requires high temperature annealing, is found to give low bandgap selectivity in InGaAs/InGaAsP based QW structures.

Laser induced disordering (LID) is a promising QWI process to achieve disordering in InGaAs/InGaAsP QW materials due to the poor thermal stability of the materials. In the photoabsorption-induced disordering (PAID) method, a continuous wave (CW) laser irradiation is absorbed in the QW regions, thereby generating heat and causing thermal induced intermixing. Although the resulting material is of high optical and electrical quality, the spatial selectivity of this technique is limited by lateral flow to around 100 µm. A modification of the PAID method, known as pulsed-PAID (P-PAID), uses high-energy Q-switched Nd:YAG laser pulses to irradiate the InP-based material. Absorption of the pulses results in disruption to the lattice and an increase in the density of point defects. These point defects subsequently interdiffuse into the QW during high temperature annealing and hence enhance the QW intermixing rate. Though P-PAID can provide spatial resolution higher than 1.25 µm and direct writing capability, the intermixed materials give low quality due to the formation of extended defects.

Of all the QWI methods, impurity induced disordering (IID) is the only process which requires the introduction of impurities into the QW materials in order to realize the intermixing process. These impurities can be introduced through focused ion beam, furnace-based impurity diffusion and also ion implantation.

IID is a relatively simple and highly reproducible intermixing process. It has the ability to provide high spatial resolution for the integration of small dimension devices and bandgap shifts can be controlled through the implantation parameters. This technique is commonly used to achieve lateral electrical and optical confinement in semiconductors such that low threshold current and single lateral-mode operation can be obtained. Furthermore, the IID process is of considerable interest for the integration of WDM systems, such as multiple wavelength laser sources, low-loss waveguides, modulators and even detectors.

The IID effect is widely accepted to consist of two stages. The first stage is to implant impurities into the QW material. The subsequent stage is to anneal the material to induce diffusion of both impurity and point defects into the QWs and barriers, and hence interdiffusion of matrix elements between QWs and barriers. In an InGaAs/InGaAsP QW system, the interdiffusion of Group V elements from barrier to well, which results in blueshifting of the bandgap energy, are believed to be caused by the diffusion of point defects generated during the implantation process, the self-interdiffusion at elevated temperature (thermal shift), and the diffusion of the implanted species.

During implantation, impurities as well as point defects, such as Group III vacancies and interstitials, are introduced into the material in selected areas. The diffusion of these point defects and impurities at elevated temperature enhances the interdiffusion rate between the QWs and barriers and hence promotes intermixing after annealing. Under the influence of injected impurities, the compositional profile of the QW is altered from a square to a parabolic-like profile. As a result, after the interdiffusion process, the local bandgap increases and the corresponding refractive index decreases.

Using the IID technique, selective area intermixing across a wafer can be obtained by using an SiO₂ implant mask with various thicknesses. However, this technique involves multiple lithography and etching steps which complicate the fabrication process.

A paper entitled "Integration process for photonic integrated circuits using plasma damage induced layer intermixing", Electronics Letters, Volume 31, 449, 1995, by B S Ooi, A C Bryce, and J H Marsh, describes a quantum well intermixing process based on reactive ion bombardment damage. In this technique, a high RF power, and hence high damage, H₂ plasma process was used to introduce point defects on the surface of samples which were then annealed to diffuse the point defects into the QW region. The plasma exposure was performed using a parallel plate reactive-ion etching (RIE) machine. Similarly, L M Lam et al, in a paper entitled "Plasma Immersion Ar⁺ Ion Implantation Induced Disorder in Strained InGaAsP Multiple Quantum Wells", Electronic Letters, Volume 34, No. 8, 16 April 1998, disclose a plasma immersion ion implantation process that uses an RIE machine. In each of these techniques, the QWI process is based on ion bombardment damage and requires multiple cycles to affect fairly modest degrees of bandgap shift.

The ability to control the bandgap across a III-V semiconductor wafer is a key requirement for the fabrication of monolithic PICs. The absorption band edge of QW structures needs to be controlled spatially across a wafer to allow the fabrication of integrated lasers, modulators, and low-loss waveguides. Although QWI techniques offer great advantages over growth and regrowth and selective epitaxial growth techniques for the bandgap engineering process, the spatial control of conventional QWI techniques is indirect and complicated.

The explosive growth of Internet traffic, multimedia services and high-speed data services has exerted pressure on telecommunications carriers to expand the capacity of their networks quickly and cost effectively. Carriers normally have three options to expand capacity, ie install new fibers, increase the bit rate of the transmission system, or employ wavelength division multiplexing (WDM). While the first option has problems of high cost and right-of-way and the second option has limited growth potential because of inherent system limitations, the third option is therefore very attractive because it is capable of manifold increase of the network capacity at a modest cost.

### Summary of the Invention

According to the present invention as defined in claim 1, a method of manufacturing a photonic integrated circuit comprising a compound semiconductor structure having a quantum well region, in which the method comprises the steps of irradiating the structure using a source of photons to generate defects, the photons having an energy (E) at least that of the displacement energy (E_{D}) of at least one element of the compound semiconductor, and subsequently annealing the structure to promote quantum well intermixing.

The preferred radiation source is a plasma, although there are a number of sources of high energy photons that can be used. Suitable plasma sources include those generated using an electron cyclotron resonance (ECR) system, an inductively coupled plasma (ICP) system, a plasma disk excited by a soft vacuum electron beam, and plasma soft x-ray (SFR) devices. Other suitable sources of high energy radiation include electrical gas discharge devices, excimer lasers, synchrotron devices, flash x-ray devices and gamma ray sources.

The method may include the step of masking a portion of the structure to control the degree of radiation damage. In this manner, the mask may be adapted to prevent intermixing entirely. However, preferably the structure is masked in a differential manner to selectively intermix the structure in a spatially controlled manner by controlling the exposure of portions of the structure in a predetermined manner.

There are a number of suitable forms of exposure masks, including binary masks, phase masks, gray masks, dielectric or metal masks, and photoresist masks. The spatial control of intermixing is advantageously controlled using a variable profile mask pattern. The International patent application number WO-01/67497 describes a method for patterning a structure by exposing a layer of photoresist through a gray scale mask. The degree of quantum well intermixing is controlled in a spatially selective manner in dependence on the optical transmittance characteristics of the gray scale mask. This technique is especially suitable for use in the present invention since it allows a mask to be constructed that can control the exposure of the structure to high energy radiation. The photoresist mask pattern may be used alone to control the degree of exposure or it may instead be used to transfer a mask pattern to an underlying material, such as a layer of dielectric material, through an etching process.

The key feature of the present invention is the use of a radiation source to cause radiation damage to a crystalline structure. To achieve this, a well defined minimum energy transfer is needed. This is called the displacement energy, E_{D}. Energy transfers exceeding E_{D} will cause atom displacement, either primary displacement, when a host ion is struck by one of the instant particles, or secondary displacement, when energy transfer is from the host atom previously struck. Energy values of E_{D} in eV for a range of group III-V materials are given in the table below.

| | |
|---|---|
| GaAs | 9/9.4 |
| InP | 6.7/8.7 |
| InAs | 6.7/8.3 |
| InSb | 5.7/6.6 |

Whilst it is known that vacuum ultraviolet (VUV) radiation can cause damage to semiconductor structures, this has always previously been investigated on the basis that this damage should be avoided, or at least repaired by annealing to ensure that these defects do not affect the operation of the device.

This novel, low cost, and simple technique can be applied for the fabrication of PICs in general, and WDM sources in particular. By applying a QWI technique in accordance with the present invention, the bandgap energy of a QW material can be tuned to different degrees across a wafer. This enables not only the integration of monolithic multiple-wavelength lasers but further extends to integrate with modulators and couplers on a single chip. This technique can also be applied to ease the fabrication and design process of superluminescent diodes (SLDs) by expanding the gain spectrum to a maximum after epitaxial growth.

The photonic integration research community currently views QWI technology as a promising approach only for two-section photonic devices as conventional QWI processes would otherwise become tedious and complicated. Although it is complex and not cost effective, researchers have instead preferred to use selective area epitaxy for multiple-section integration. The present invention demonstrates that the application of QWI is not limited to two sectional devices. In addition, the technique is more cost effective, and offers a higher throughput and higher yield compared to selective area epitaxy.

### Brief Description of the Drawings

Examples of the present invention will now be described in detail with reference to the accompanying drawings, in which:
Figure 1 is a schematic diagram of an example of an ECR system;
Figure 2 is a schematic representation of an InGaAs/InGaAsP SQW layer structure and a band diagram for the structure;
Figures 3A and 3B are graphs illustrating the PL spectra of samples exposed to Ar plasma;
Figure 4 is a graph illustrating the relationship between Ar exposure time and relative bandgap energy shift for different microwave powers;
Figure 5 is a graph illustrating the relationship between process temperature and relative bandgap energy shift;
Figure 6 is a graph illustrating the relationship between process pressure and relative bandgap energy shift;
Figure 7 is a schematic diagram of a sample partially masked by a layer of photoresist;
Figure 8 is a graph illustrating the PL spectra obtained from the sample of Figure 7 after exposure to an Ar plasma;
Figure 9 is a graph illustrating the relationship between RF power and relative bandgap energy shift;
Figure 10 is a graph illustrating the relationship between microwave power and relative bandgap energy shift;
Figure 11 is a graph illustrating the relative bandgap energy shift for samples exposed to Ar plasma with different SiO₂ mask thicknesses;
Figure 12 is a schematic diagram of a broad area gain guided laser; and,
Figure 13 is a graph illustrating the normalized spectra of the device of Figure 12.

### Detailed Description

The present invention is based on the discovery that a more effective form of plasma induced QWI can be achieved using high energy radiation, such as the VUV radiation generated in an ECR generated plasma. This plasma process operates in a totally different regime compared to that described in earlier plasma induced disordering QWI techniques. In an ECR, the microwave power control allows for the generation of high energy radiation that is not found in a conventional RIE machine. As a result, the QWI blue shift obtained using high energy radiation is significantly greater.

In an ECR system, a magnetic field is applied with an exciting electromagnetic wave. Electrons under these fields undergo a circular or orbital motion with a radius relating to the strength of the fields, and rotating at a frequency known as electron cyclotron frequency. If the frequency of the electromagnetic wave is equal to the cyclotron frequency, there will be a phase coherence causing the electrons to continuously gain energy. Under this condition, emission transfer of energy from the exciting electromagnetic field to the electrons takes place in what is known as the resonant process. In this resonant process, the electrons in the bulk of the plasma gain their energy from the exciting microwave and subsequently transfer the energy to the molecules via collisions, causing electron impact ionizations and generating a high plasma density. The highly ionized ions emit photons with VUV line emissions.

ECR plasma is becoming increasingly popular in microelectronics processing such as etching and thin film deposition due to its ability to sustain highly dissociated and highly ionized plasmas at relatively low pressures and temperatures. It has the capability to operate at lower pressure (typically 10⁻³ to 10⁻² Torr (1 Torr=133.32 Pascals)) than a conventional RIE RF plasma and its degree of ionization can be as high as 10% or so in some cases.

Resonance, or enhanced energy absorption, occurs when the frequency of the alternating electric field equals the cyclotron frequency. At this condition, the electron's spiral motion is in phase with the alternating electric field, allowing it to be accelerated resonantly with each change in polarity. At the industrial microwave frequency of 2.45 GHz, resonance occurs with a permanent magnet of 873G. For resonant absorption of energy to occur efficiently, the electrons must undergo their cyclotron orbits without collision with neutrals. Collisions interfere with energy absorption due to energy transfer to the neutrals and randomization of direction. As a general rule, collisions result in inefficient electron cyclotron heating at pressures above 20 mTorr. In an efficient ECR discharge, ion and electron densities up to 10¹²cm⁻³ are achievable. This is roughly 100 to 1000 times the density achievable in plasma generated by conventional RIE systems.

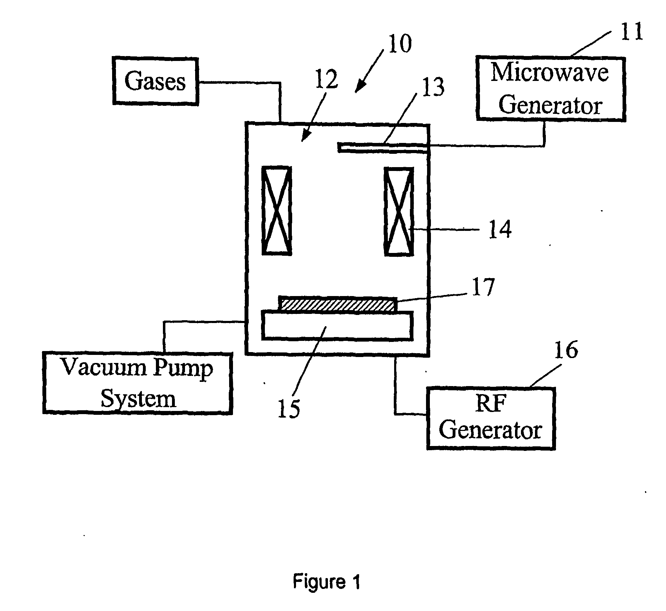

The ECR system used in the processing of the samples described below was a Plasma Quest Series II PQM-9187-A system. This is shown in Figure 1. The system 10 consists of a microwave generator 11 of 2.45 GHz that is fed into the ECR cavity 12 through a quartz window. The microwave power ranges from 0-1500 W. It is attached with a three-stub tuner, which consists of three impedance matching stubs installed within a 9-inch length of waveguide 13. This is used to reduce the reflected power of microwave energy directed to an easy-to-tune plasma source or customer load. Additional Nd-Fe-B permanent magnets 14 of alternating polarity are arranged around the perimeter of the reactor and embedded in the grounded upper electrode. This arrangement produces a magnetic field which better confines the plasma. It focuses the plasma ions into the center of the chamber, away from the chamber wall, and thereby reduces the loss of charged species to the wall.

The ECR reactor also consists of a sample chuck 15 that is connected to a 13.56 MHz RF power supply 16. The maximum power producible by the RF generator is 500 W. The microwave power controls the amount of dissociation and generation of reactive species. On the other hand, the RF source provides the bias to the substrate and thus controls the ion flux to the substrate, enhancing the directionality of the process.

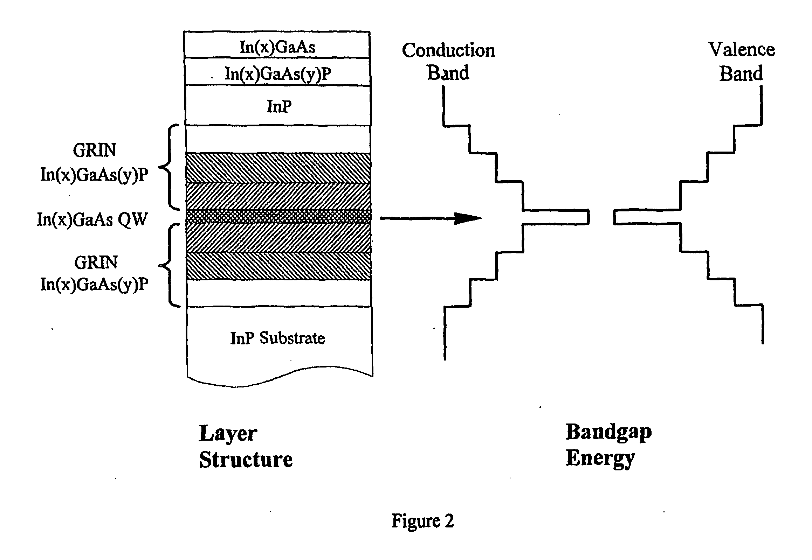

The In_{z}Ga_{l-z}As/InₓGaₗ₋ₓAs_{y}P_{l-y} structures used in the examples described below were grown by metal organic chemical vapour deposition (MOCVD) on an InP substrate. The single quantum well (SQW) region is undoped and consists of a 5.5 nm wide In_{z}Ga_{1-z}As QW, with 12 nm InₓGaₗ₋ₓAs_{y}P_{l-y} (λ_{g}=1.26 µm) barriers. The active region was bounded by step graded index (GRIN) InₓGaₗ₋ₓAs_{y}P_{l-y} confining layers. The thickness and composition of these layers were 50 nm of λ_{g}=1.18 µm and 80 nm of λ_{g}=1.05 µm, respectively. The structure, which was lattice matched to InP throughout, was completed with a 1.4 µm InP upper cladding layer and a layer of 0.65 µm InₓGaₗ₋ₓAs_{y}P_{l-y} followed by a 0.1 µm In_{z}Ga_{l-z}As which functions as the contact layer. The lower cladding layer was sulfur-doped to a concentration of 2.5x10¹⁸cm⁻³. The first upper cladding layer (InP) was doped with Zn to a concentration of 7.4x10¹⁷cm⁻³ and the subsequent layer was doped with 2x10¹⁸cm⁻³ and 1.3x10¹⁹cm⁻³ concentration of Zn respectively. A summary of the layer structure and graphical interpretation is given in Table 1 and Figure 2, respectively.

**Table 1**

| **Layer** | **Thickness (nm)** | **Material** | **Ts** | **(x)** | **Dopant** | **Type** | **Conc(cm**^{**-3**}**)** |
|---|---|---|---|---|---|---|---|
| 11 | 100 | In(x)GaAs | 650 | 0.53 | Zn | p | 8.000e+18 |
| 10 | 50 | InGaAsP, λg=1.18 | 650 | | Zn | p | 2.000e+18 |
| 9 | 1400 | InP | 650 | | Zn | p | 6.000e+17 |
| 8 | 80 | InGaAsP, λg=1.05 | 650 | | | u | |
| 7 | 50 | InGaAsP, λg=1.18 | 650 | | | u | |
| 6 | 12 | aInGaAsP, λg=1.26 | 650 | | | u | |
| 5 | 5.5 | In(x)GaAs | 650 | 0.53 | | u | |
| 4 | 12 | InGaAsP, λg=1.26 | 650 | | | u | |
| 3 | 50 | InGaAsP, λg=1.18 | 650 | | S | n | 5.000c+17 |
| 2 | 80 | InGaAsP, λg=1.05 | 650 | | S | n | 5.000e+17 |
| 1 | 1000 | InP | 650 | | S | n | 2.000e+18 |
| - | - | *InP Substrate | - | | | | |

The GRIN structure is used to produce better optical confinement due to the difference in refractive index, i.e. higher refractive index in the QW as compared to the barriers. The lower GRIN region is doped with S (n-type), but the upper GRIN region (layer 7-8) is not doped with p-type Zn to prevent it from diffusing into the QW region during the QWI stage, hence degrading the quality of the active layer. The top InGaAs layer is used as a contact layer, and an InGaAsP layer is sandwiched between the InP and InGaAs layer so as not to cause an abrupt change from InP structure to InGaAs structure.

Samples 17 were first cleaned and cleaved into size of 2x2 mm². They were then exposed to Ar plasma within the ECR arrangement 10 shown in Figure 1 at different process conditions. For the first set of samples subjected to plasma treatment, the RF and microwave powers were fixed at 450 W (self-DC bias around -35 V) and 1400 W respectively, with an Ar flow rate of 50 sccm and process pressure of 30 mTorr. The exposure time was varied from 1 to 15 minutes. Another set of samples was then exposed to the Ar plasma with the same process conditions with the exception that the microwave power was reduced to 800 W (self-DC bias around -60 V). The exposure time was varied from 1 to 9 minutes. After plasma exposure, the samples were subsequently annealed at 600°C for 2 minutes using a rapid thermal processor (RTP). A GaAs proximity cap was used during the annealing stage in order to provide As over pressure to the samples.

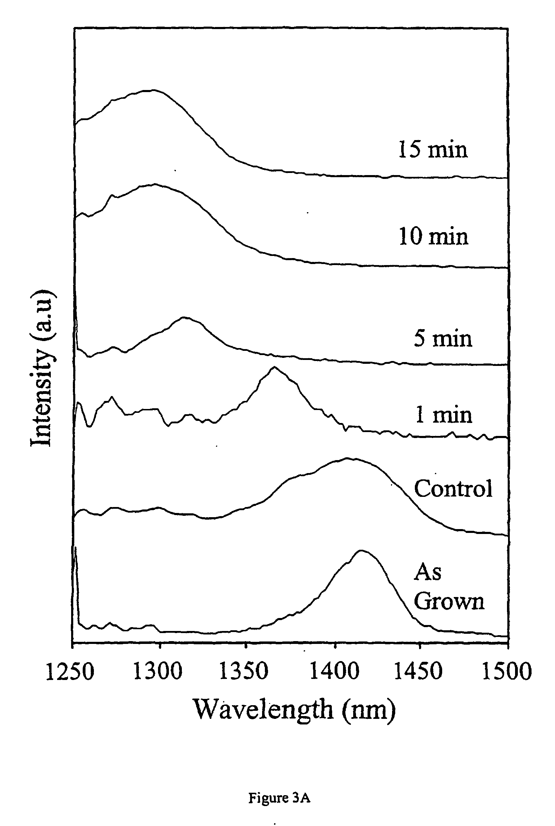

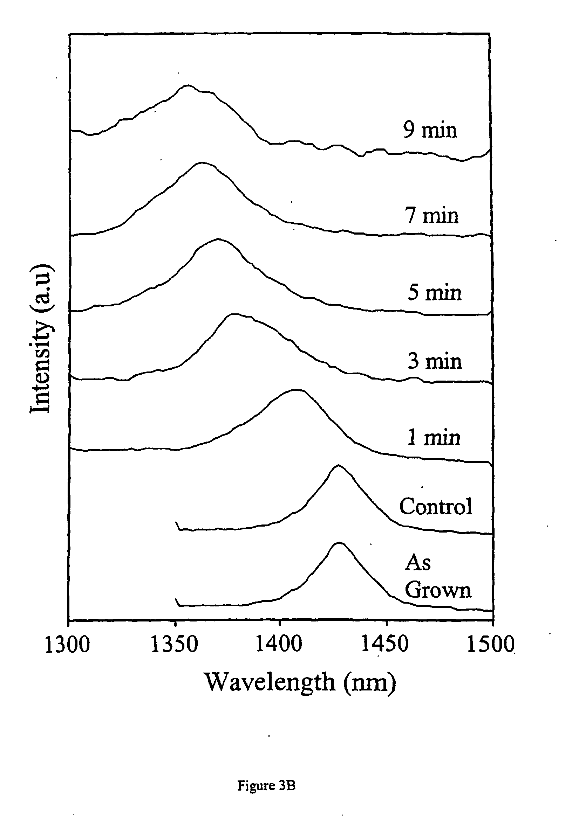

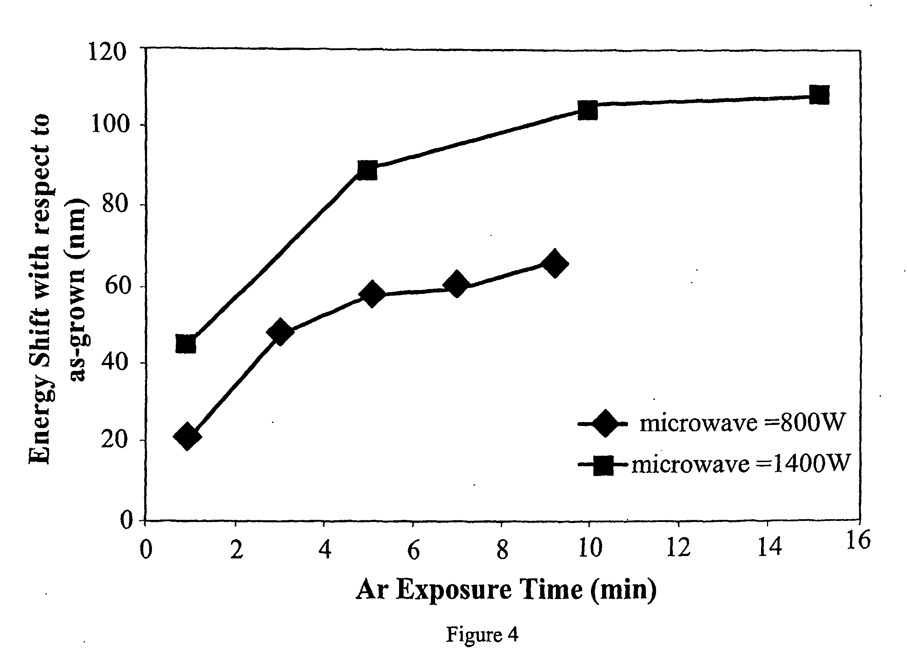

Figures 3A and 3B show the PL spectra of the samples exposed to Ar plasma at different times and microwave powers of 1400 W and 800 W, respectively. Figure 4 shows the relative bandgap shift with respect to the as-grown sample, as a function of exposure time, for Ar plasma generated using RF 450 W and microwave powers of 800 W and 1400 W, respectively.

As can be seen from Figure 4, the QWI effect, which causes the broadening of the bandgap energy and blue shifting of the luminescence wavelength, can be observed for the samples exposed to the Ar plasma. The degree of intermixing increases gradually with increasing exposure time for samples exposed at 1400 W. The bandgap shift saturated at about 106 nm (72 meV) after 10 minutes of plasma treatment. The saturation in energy shift implies that the maximum point defects generated by both ion bombardments and radiation damage saturates after an exposure time of 10 minutes. The samples exposed to 800 W produced results of similar trend to that of 1400 W, but with lower degrees of blue shift. This could be attributed to the use of lower microwave power, and hence lower ionization of the Ar plasma. The highest attainable blue shift under this exposure condition was found to be around 66 nm (42 meV) for the sample treated for 9 minutes.

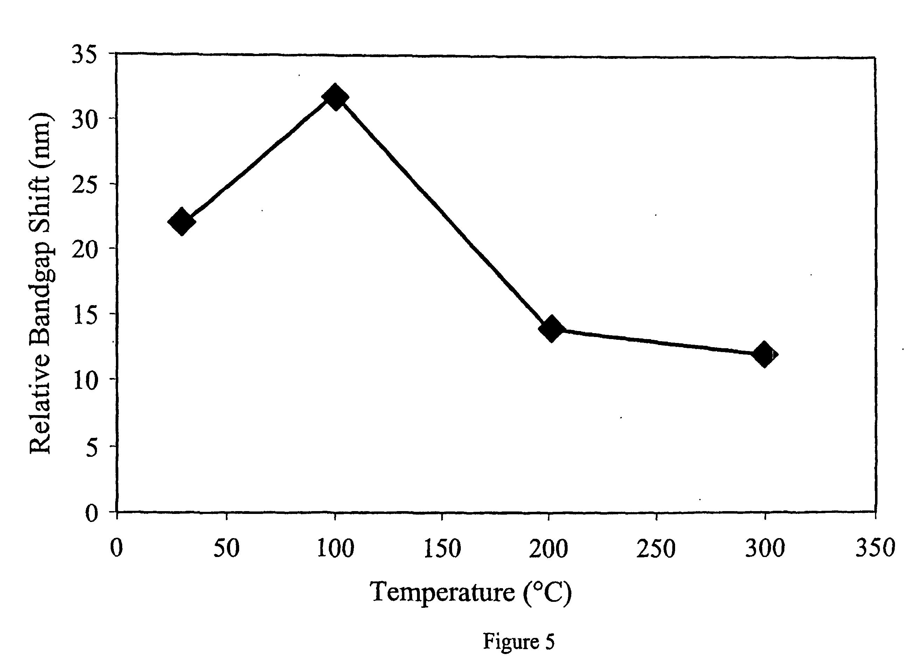

As can be seen from Figure 5, there is no linear relationship governing the bandgap energy shift and the process temperature. A maximum bandgap shift of 32 nm was obtained at a process temperature of 100°C. It is generally expected that higher temperature would produce higher degree of QWI under the ion bombardment damage process. However, this phenomenon was not observed here. It could thus be concluded that the concentration of the damage induced by this process is below a certain threshold to activate QWI.

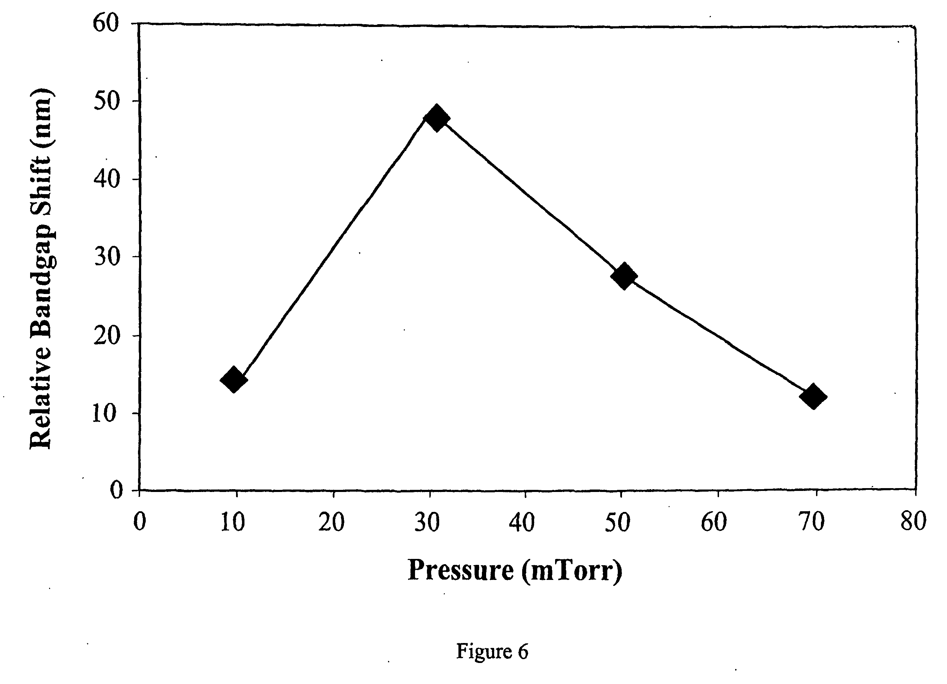

Figure 6 shows the bandgap energy shift with respect to different process pressures. The bandgap energy shift increased to a maximum of 49 nm at process pressure of 30 mTorr and gradually decreases with increasing process pressure. From the results obtained, it could be explained that as the process pressure increased from 10 mTorr to 30 mTorr, the density of the neutral and ionized species of the plasma increased. Thus, a higher amount of damage is produced, resulting in a higher degree of intermixing. However, as the pressure continues to increase, the mean free path of the ions becomes shorter. This causes the amount of ions and neutral species colliding onto the sample surface to reduce significantly, thus reducing the amount of damage induced. Higher ionization due to increasing process pressure should produce greater radiation damage. However, the results indicate that the radiation intensity change is minimal and its effect on QWI over a range of different pressures remains fairly constant.

QWI is generally only useful if it can be localized to desired areas of the semiconductor, i.e. it is able to intermix selectively. Selectivity is an important aspect in a process as it provides the possibility of integration. For QWI, interface sharpness between the intermixed and unintermixed region is known as the spatial resolution. High spatial resolution is necessary in intermixing processes as it ensures the compactness in device integration.

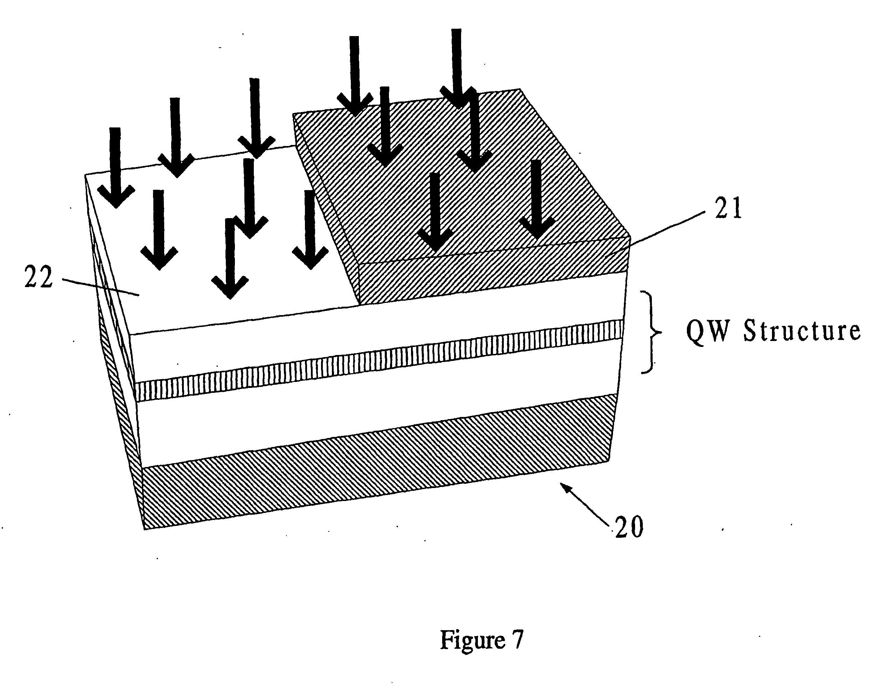

In order to study the selectivity of the plasma process, samples 20 of 2 x 4 mm² were prepared (Figure 7). Half of the samples were then patterned with photoresist 21. These samples 20 were exposed to an Ar plasma of RF 450 W and microwave 1400 W for 5 minutes. The portion masked with photoresist 21 is shielded from the damage caused by the Ar plasma exposure and thus would undergo none or minimal QWI after the RTP process.

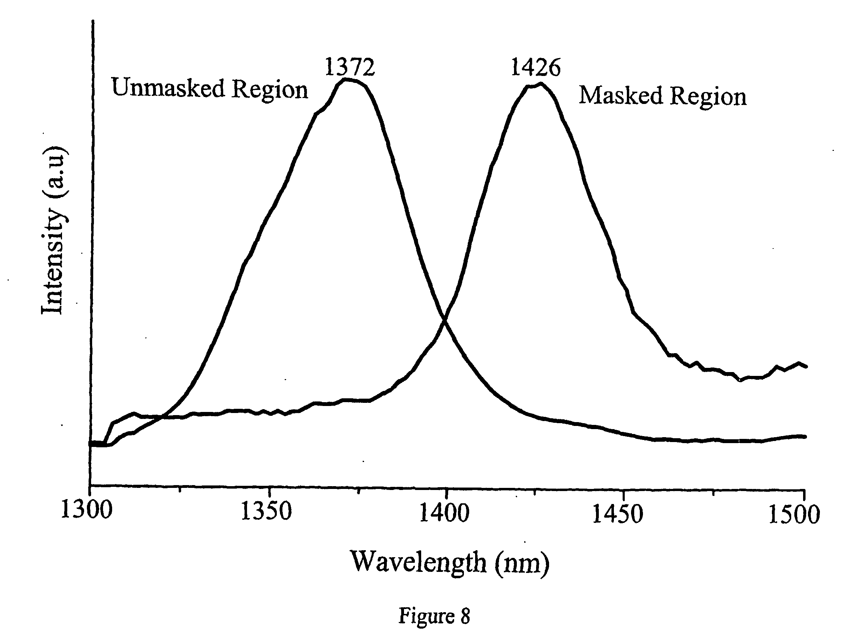

Figure 8 shows the PL spectra obtained from the sample 20 after Ar exposure and subsequent thermal annealing. As can be seen from the graph, the portion masked with a layer of photoresist 21 underwent a small amount of bandgap shift (∼10 nm), whereas the portion 22 exposed to the plasma exhibited a much larger bandgap shift of 64 nm, thus producing a relative bandgap difference of 54 nm between masked and unmasked regions. This result strongly indicates that high selectivity is obtainable in the InGaAs-InGaAsP samples using only photoresist as a masking layer. The small amount of bandgap shift in the masked region could be due to the bandgap modification induced by thermal related effects.

The plasma generated using only RF power is expected to predominantly create ion bombardment damage. This is mainly due to the high potential difference between the plasma and the semiconductor, which could be as high as 130 eV. By exposing the sample with such plasma, the QWI mechanism in an ion-bombardment dominated plasma environment can be investigated.

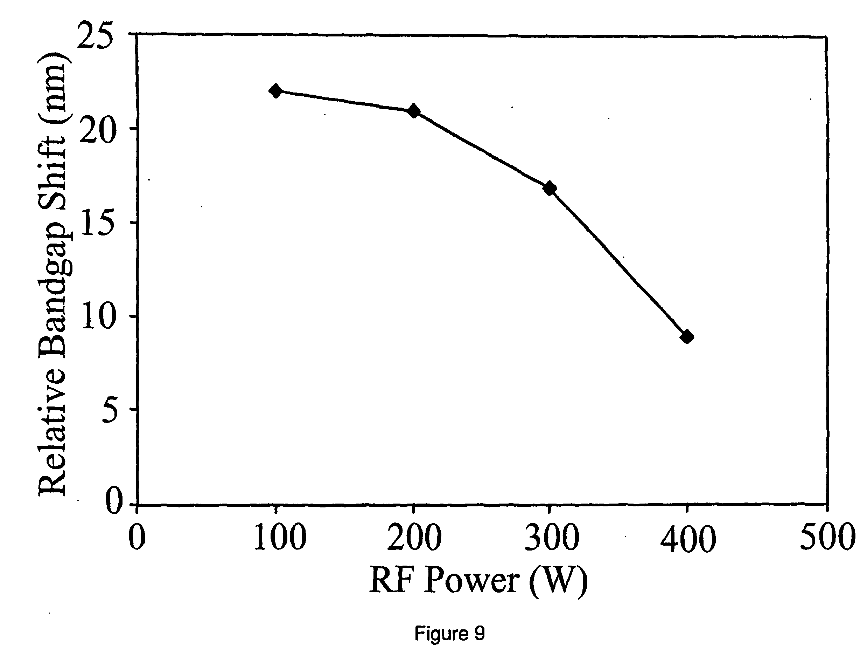

A set of samples was exposed to Ar plasma generated using different RF conditions, while other process parameters were held constant. All the exposures were performed for 5 minutes. Figure 9 shows the relative bandgap shift as a function of RF power. As can be seen from Figure 9, samples treated with plasma under RF-only conditions exhibit insignificant bandgap shift, with a maximum shift of 22 nm (10 meV). The bandgap shifts under different RF values were also rather small.

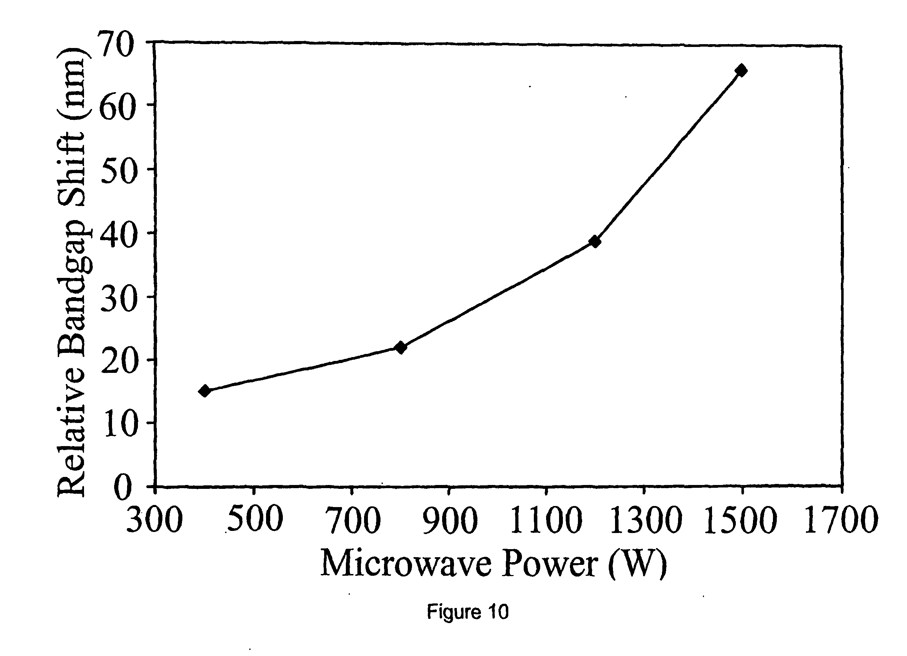

A further set of samples was then exposed to plasma generated by different microwave conditions, while other process parameters were held constant. All the exposures were performed for 5 minutes. Upon exposure, the samples were annealed at 600°C for 2 minutes. Figure 10 shows the relative bandgap energy shift as a function of microwave power.

As can be seen from Figure 10, samples treated with plasma under microwave-only conditions produced a bandgap energy shift as large as 66 nm (42 meV). The amount of bandgap shift also increases with increasing microwave power. This result implies that high-energy VUV radiation generated by high-density ECR plasma has a stronger influence on the QWI effect than ion bombardment. It thus plays an important role in QWI in the InGaAs-InGaAsP structures using this process.

Table 2 below provides a summary of the process variables investigated above, showing the potential operating range of each variable and the preferred operating range.

**Table 2**

| | **Potential Operating Range** | **Preferred Operating Range** |
|---|---|---|
| **RF power** | 0 ∼ 500 W | 0 W |
| **Microwave power** | 300 ∼ 3000 W | 1000 ∼ 2000 W |
| **Process temperature** | 25 ∼ 500°C | 25 ∼ 200° C |
| **Process pressure** | 0.1 ∼ 100 mTorr | 20 ∼ 50 mTorr |
| **Exposure time** | 30 s *∼* 1 hr | 4 ∼ 14 min |

In the following example, a layer of SiO₂ is used to act as an Ar plasma exposure mask to investigate the rate of intermixing with respect to the SiO₂ thickness deposited on InGaAs/InGaAsP MQW. The ability to control the amount of intermixing with different SiO₂ thicknesses would enable the lateral variation of bandgap energy in the sample. This would enable the realization of devices requiring different operating wavelengths across the sample, such as multiple wavelength lasers.

InGaAs/InGaAsP MQW samples were cleaved into 2 x 2 mm², and SiO₂ of different thicknesses were deposited on the samples using a PECVD system. The SiO₂ thicknesses ranged from 100 nm to 1200 nm. Four samples were used for each SiO₂ thickness; this was done in order to study the repeatability of the process.

All the samples were exposed to an Ar plasma of RF 450 W and microwave 1400 W for 10 minutes. After exposure, two of the samples for each SiO₂ thickness were placed in a solution of HF:H₂O in the ratio of 2:1. This is to remove the SiO₂ layer on the samples before going through the annealing process. Thus, the effect of annealing with and without SiO₂ capping could be studied. The samples were then annealed in an RTP at a temperature of 590°C for 2 minutes. PL measurements were then performed to analyze the degree of QWI.

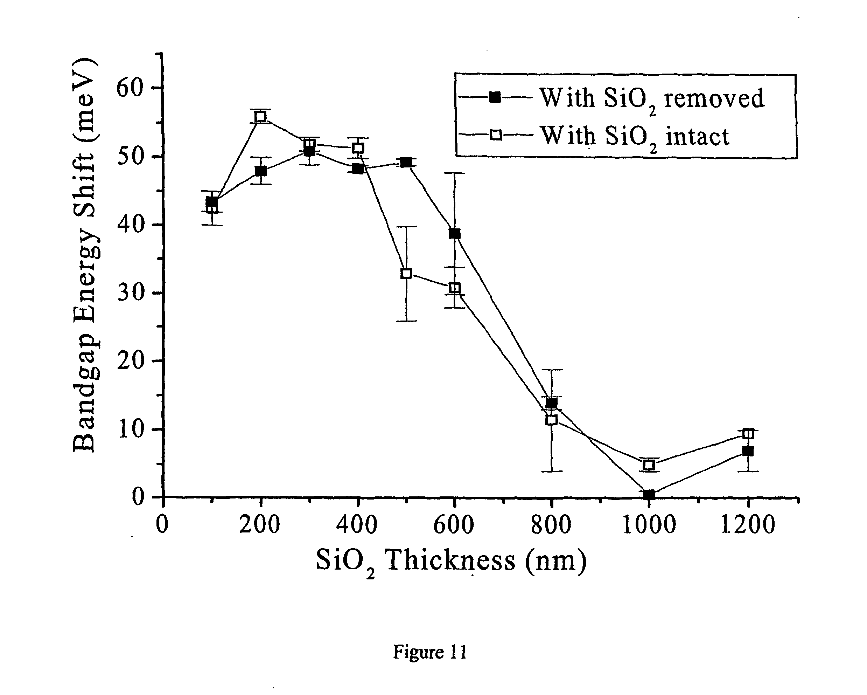

Figure 11 shows the relative bandgap energy shift for samples exposed to the Ar plasma with different SiO₂ thicknesses. As can be seen from Figure 11, the degree of intermixing decreased gradually as the thickness of SiO₂ increases. However, the degree of intermixing remains rather constant, having a bandgap shift in the range of 40-50 meV, when the SiO₂ thickness is below 500 nm. No significant bandgap shift was observed for an SiO₂ cap thickness above 800 nm. In the SiO₂ thickness range of 500-800 nm, the degree of intermixing reduced significantly with increasing thickness.

Accordingly, we have shown that QWI in InGaAs/InGaAsP MQW using Ar plasma exposure is controllable by altering the thickness of SiO₂ deposited on the sample before exposure. The ability to control the degree of intermixing enables the fabrication of devices which require different bandgap energy across a sample. Devices such as multiple wavelength lasers for WDM applications could be realized by controlling the thickness of the SiO₂ across the wafer before Ar exposure. With the invention of the novel gray scale mask lithographic technique described in the International patent application number WO-01/67497, this fabrication would be further simplified, as it requires only one-step RIE processing to transfer various thickness of SiO₂ onto the samples. Alternatively, the mask may consist only of a photoresist pattern having different thicknesses applied using the same gray scale mask technique.

In order to investigate the lasing wavelength of the materials after QWI, broad area gain guided lasers were fabricated from an as-grown sample (no plasma treatment and annealing), a control sample (no plasma treatment but annealed), and an Ar plasma intermixed sample.

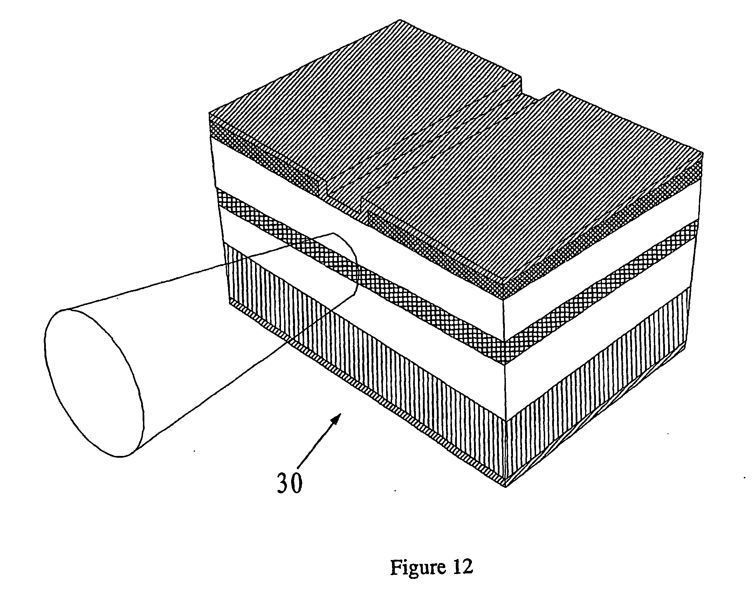

Samples of 6 x 6 mm² were cleaved along the crystal orientation from an InGaAs/InGaAsP MQW wafer. They were then exposed to Ar plasma of RF 450 W and microwave 800 W for 5 minutes. An annealing step at 590°C for 120 seconds was subsequently carried out to promote QWI. The samples were then coated with a 200 nm PECVD SiO₂ dielectric cap. Next, 50 µm stripe windows were defined using photolithography and both dry and wet etching were used to open the windows. To minimize RIE damage from the CF₄ and O₂ process, dry etching was first carried out for 5 minutes, followed by wet-etching using buffered HF for 10 seconds, to remove the remaining 75 nm of SiO₂. These lasers are gain-guided since the injected current produced population inversion and a subtle waveguide effect only in the 50 µm stripe regions. After this, front contact metallization (p-type: Ti/Au, 50 nm/200 nm) was done using an electron beam evaporator. Samples were then thinned to a thickness of around 180 µm. Another metallization for back contact (n-type: Au/Ge/Au/Ni/Au, 14 nm/14 nm/14 nm/11 nm/200 nm) were evaporated and the whole fabrication was completed by annealing the samples using RTP at 360°C for 60 seconds. The processed samples were then scribed into individual lasers with different cavity lengths for characterization. A schematic diagram of a bandgap shifted oxide stripe laser 30 is given in Figure 12.

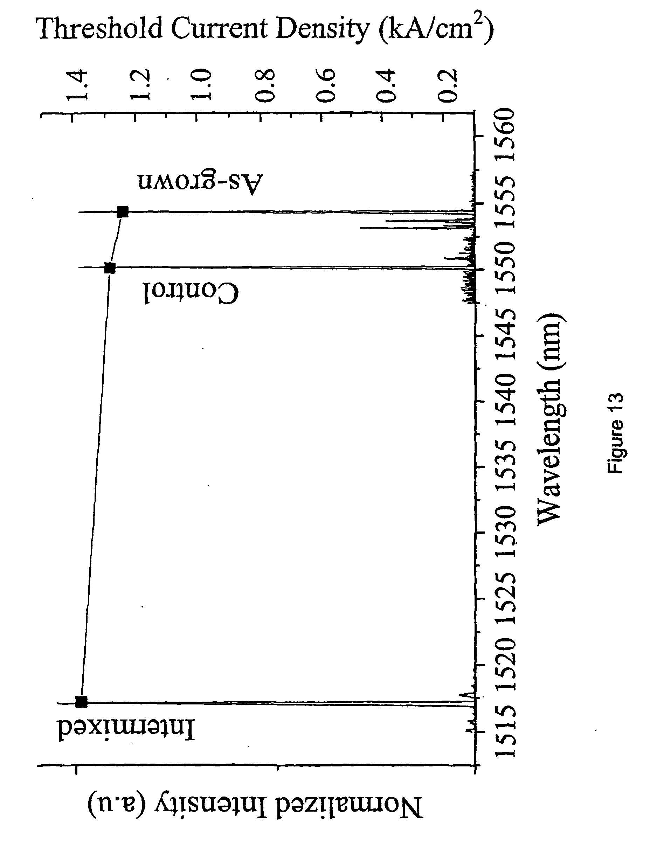

Figure 13 shows the as-grown, control and Ar plasma intermixed laser spectra. From the Figure, the control samples and as-grown samples exhibit almost similar peak lasing wavelength at 1.55 µm, and the Ar plasma intermixed lasers give a peak lasing wavelength at 1.517 µm, a shift of 38 nm.

## Claims

1. A method of manufacturing a photonic integrated circuit comprising a compound semiconductor structure having a quantum well region, comprising the steps of irradiating the structure using a source of photons to generate defects, the photons having an energy (E) at least that of the displacement energy (E_{D}) of at least one element of the compound semiconductor, and subsequently annealing the structure to promote quantum well intermixing.

2. A method according to claim 1, in which the radiation source is a plasma.

3. A method according to claim 2, in which the plasma source is generated using an electron cyclotron resonance (ECR) system, an inductively coupled plasma (ICP) system, a plasma disk excited by a soft vacuum electron beam, or plasma soft x-ray (SFR) devices.

4. A method according to claim 1, in which the radiation source is one selected from a group consisting of electrical gas discharge devices, excimer lasers, synchrotron devices, flash x-ray devices and gamma ray sources.

5. A method according to any preceding claim, including the step of masking a portion of the structure to control the degree of radiation damage.

6. A method according to claim 5, in which the mask is adapted to prevent intermixing entirely.

7. A method according to claim 5, in which the structure is masked in a differential manner to selectively intermix the structure in a spatially controlled manner by controlling the exposure of portions of the structure in a predetermined manner.

8. A method according to any of claims 5 to 7, in which the mask is selected from a group consisting of binary masks, phase masks, gray masks, dielectric or metal masks, and photoresist masks.

9. A method according to any preceding claim, in which spatial control of intermixing is controlled using a variable profile mask pattern.

10. A method according to any preceding claim further comprising the steps of forming a photoresist on the structure and differentially exposing regions of the photoresist in a spatially selective manner in dependence on the degree of quantum well intermixing required, and subsequently developing the photoresist.

11. A method according to claim 10, comprising the step of applying an optical mask to the photoresist and exposing the photoresist through the optical mask, the optical mask having an optical transmittance that varies in a spatially selective manner.

12. A method according to claims 11, in which the optical mask is a Gray scale mask.

13. A method according to any of claims 10 to 12, in which the photoresist is applied to a masking layer.

14. A method according to claim 13, in which the masking layer is a dielectric.

15. A method according to claims 13 or 14, further comprising the step of etching the structure with the developed photoresist in situ to provide a differentially etched masking layer.

16. A method according to any preceding claim, in which an electron cyclotron resonance system is used to generate a plasma, wherein the microwave power of the ECR system is between 300 and 3000 W, more preferably between 1000 and 2000 W, the process temperature is between 25 and 500°C, more preferably between 25 and 200°C, the process pressure is between 0.1 and 100 mTorr, more preferably between 20 and 50 mTorr (1mTorr=0.13 Pascals), and the exposure time is between 30 seconds and 1 hour, more preferably between 4 and 14 minutes.

## Patentansprüche

1. Verfahren zur Herstellung einer photonischen integrierten Schaltung (photonic integrated circuit) umfassend eine Verbundhalbleiterstruktur mit einem Quantenschacht bzw. -topfbereich, umfassend die Schritte des Bestrahlens der Struktur unter Verwendung einer Photonenquelle um Defekte zu erzeugen, wobei die Photonen eine Energie (E) aufweisen, entsprechend wenigstens der der Verdrängungsenergie (E_{D}) von wenigstens einem Element des Halbleiters und nachfolgend des Glühens der Struktur um ein Vermischen des Quantenschachtes bzw. -topfes zu unterstützen.

2. Verfahren nach Anspruch 1, wobei die Strahlungsquelle ein Plasma ist.

3. Verfahren nach Anspruch 2, wobei die Plasmaquelle unter Verwendung eines Elektronen-Cyclotron-Resonanz (ECR) Systems, eines induktiv gekoppelten Plasma (ICP) Systems, einer mit einem weichen Vakuum Elektronenstrahl (soft vauum electron beam) angeregten Plasmascheibe oder weichen Plasma Röntgenstrahl (SFR) Vorrichtung erzeugt wird.

4. Verfahren nach Anspruch 1, wobei die Strahlungsquelle eine ist, ausgewählt aus einer Gruppe bestehend aus elektrischen Gasentladungseinrichtungen, Excimerlasern, Synchrotoneinrichtungen, Rötgenstrahlblitzeinrichtungen und Gammastrahlquellen.

5. Verfahren nach einem der vorangehenden Ansprüche, umfassend den Schritt des Maskierens bzw. Abdeckens eines Bereichs der Struktur um das Ausmaß der Strahlungsschäden zu kontrollieren.

6. Verfahren nach Anspruch 5, wobei die Maske bzw. Abdeckung geeignet ist, um ein vollständiges Vermischen zu verhindern.

7. Verfahren nach Anspruch 5, wobei die Struktur auf unterschiedliche Weise maskiert bzw. abgedeckt wird, um die Struktur auf eine räumlich kontrollierte Weise selektiv zu vermischen, um die Aussetzung der Bereiche der Struktur auf vorbestimmte Weise zu kontrollieren.

8. Verfahren nach einem der Ansprüche 5 bis 7, wobei die Maske bzw. Abdeckung ausgewählt wird aus einer Gruppe, bestehend aus binären Masken, Phasenmasken, Graumasken, dielektrische oder metallische Masken und Fotolackmasken.

9. Verfahren nach einem der vorangehenden Ansprüche, wobei eine räumliche Kontrolle der Vermischung unter Verwendung eines veränderbaren Profilmaskenmusters gesteuert wird.

10. Verfahren nach einem der vorangehenden Ansprüche, umfassend die Schritte des Bildens eines Fotolacks auf der Struktur und unterschiedlichen Belichtens der Bereiche des Fotolacks auf eine räumlich ausgewählte Weise abhängig von dem erforderten Ausmaß des Vermischens des Quantenschachts bzw. -topfs und nachfolgend Entwickelns des Fotolacks.

11. Verfahren nach Anspruch 10, umfassend den Schritt des Aufbringens einer optischen Maske auf den Fotolack und Belichtens des Fotolacks durch die optische Maske, wobei die optische Maske eine optische Durchlässigkeit aufweist die sich in einer räumlich ausgewählten Weise verändert.

12. Verfahren nach Anspruch 11, wobei die optische Maske bzw. Abdeckung eine Grauskala-Abdeckung ist.

13. Verfahren nach einem der Ansprüche 10 bis 12, wobei der Fotolack auf eine Maskierungs- bzw. Abdeckschicht aufgebracht wird.

14. Verfahren nach Anspruch 13, wobei die Maskierungs- bzw. Abdeckschicht schicht ein Dielektrikum ist.

15. Verfahren nach Anspruch 13 oder 14, des weiteren umfassend den Schritt des in situ Ätzens der Struktur mit dem entwickelten Fotolack um eine unterschiedlich geätzte Maskierungs- bzw. Abdeckschicht bereitzustellen.

16. Verfahren nach einem der vorangehenden Ansprüche, wobei ein Elektronen-Cyclotron-Resonanz Systems verwendet wird, um ein Plasma zu erzeugen, wobei die Mikrowellenleistung des ECR Systems zwischen 300 und 3000 W liegt, bevorzugter zwischen 1000 und 2000 W, die Verfahrenstemperatur zwischen 25 und 500°C liegt, bevorzugter zwischen 25 und 200°C, der Verfahrensdruck zwischen 0,1 und 100 mTorr liegt, bevorzugter zwischen 20 und 50 mTorr (1mTorr = 0,13 Pa), und die Bestrahlungsdauer zwischen 30 Sekunden und einer Stunde liegt, bevorzugter zwischen 4 und 14 Minuten.

## Revendications

1. Méthode de fabrication d'un circuit intégré photonique comprenant une structure à semi-conducteur composé ayant une région de puits quantiques, comprenant les étapes d'irradiation de la structure en utilisant une source de photons pour générer des défauts, les photons ayant une énergie (E) au moins égale à celle de l'énergie de déplacement (E_{D}) d'au moins un élément du semiconducteur composé, et ensuite de recuit de la structure pour favoriser l'inter-mélange des puits quantiques.

2. Méthode selon la revendication 1, dans laquelle la source de rayonnement est un plasma.

3. Méthode selon la revendication 2, dans laquelle la source de plasma est générée en utilisant un système de résonance cyclotronique des électrons (ECR), un système à plasma à couplage inductif (ICP), un disque à plasma excité par un faisceau d'électrons sous vide primaire, ou des dispositifs à rayons X mous de plasma (SFR).

4. Méthode selon la revendication 1, dans laquelle la source de rayonnement est une source sélectionnée dans un groupe constitué par des dispositifs de décharge électrique dans un gaz, des lasers excimers, des dispositifs synchrotroniques, des dispositifs à rayons X à éclair et des sources de rayons gamma.

5. Méthode selon l'une quelconque des revendications précédentes, comprenant l'étape de masquage d'une partie de la structure pour commander le degré de détérioration par le rayonnement.

6. Méthode selon la revendication 5, dans laquelle le masque est adapté pour complètement empêcher un intermélange.

7. Méthode selon la revendication 5, dans laquelle la structure est masquée d'une manière différentielle pour inter-mélanger de manière sélective la structure d'une manière commandée spatialement en commandant l'exposition de parties de la structure d'une manière prédéterminée.

8. Méthode selon l'une quelconque des revendications 5 à 7, dans laquelle le masque est sélectionné dans un groupe constitué par des masques binaires, des masques de phase, des masques de gris, des masques diélectriques ou métalliques et des masques de photorésist.

9. Méthode selon l'une quelconque des revendications précédentes, dans laquelle la commande spatiale d'inter-mélange est réalisée en utilisant un motif de masque à profil variable.

10. Méthode selon l'une quelconque des revendications précédentes, comprenant en outre les étapes de formation d'un photorésist sur la structure, et d'exposition de manière différentielle de régions du photorésist d'une manière spatialement sélective en fonction du degré d'inter-mélange des puits quantiques nécessaire, et ensuite de développement du photorésist.

11. Méthode selon la revendication 10, comprenant l'étape d'application d'un masque optique sur le photorésist et d'exposition du photorésist à travers le masque optique, le masque optique ayant une transmittance optique qui varie d'une manière spatialement sélective.

12. Méthode selon la revendication 11, dans laquelle le masque optique est un masque à échelle de gris.

13. Méthode selon l'une quelconque des revendications 10 à 12, dans laquelle le photorésist est appliqué sur une couche de masquage.

14. Méthode selon la revendication 13, dans laquelle la couche de masquage est un diélectrique.

15. Méthode selon la revendication 13 ou 14, comprenant en outre l'étape d'attaque de la structure avec le photorésist développé in situ afin de fournir une couche de masquage attaquée de manière différentielle.

16. Méthode selon l'une quelconque des revendications précédentes, dans laquelle un système de résonance cyclotronique des électrons est utilisé pour générer un plasma, la puissance des micro-ondes du système ECR étant entre 300 et 3000 W, de manière plus préférée entre 1000 et 2000 W, la température de traitement étant entre 25 et 500°C, de manière plus préférée entre 25 et 200°C, la pression de traitement étant entre 0,1 et 100 mTorr, de manière plus préférée entre 20 et 50 mTorr (1 mTorr = 0,13 Pascal), et le temps d'exposition étant entre 30 secondes et 1 heure, de manière plus préférée entre 4 et 14 minutes.
